# EUROPEAN PATENT APPLICATION

(11) **EP 3 598 562 A1**
(43) Date of publication of application: **22.01.2020**
(21) Application number: 18766717.5
(22) Date of filing: 01.03.2018
(51) Int. Cl.: H01M 10/36, H01M 4/48, H01M 10/38

(54) **SECONDARY BATTERY**

(30) Priority: 16.03.2017 JP 2017051499
(71) Applicant: Kabushiki Kaisha Nihon Micronics, Musashino-shi, Tokyo 180-8508 (JP)
(72) Inventor: SAITO, Tomokazu, Musashino-shi Tokyo 180-8508 (JP); TAKANO, Hikaru, Musashino-shi Tokyo 180-8508 (JP); SATO, Yuki, Musashino-shi Tokyo 180-8508 (JP); TSUNOKUNI, Kazuyuki, Musashino-shi Tokyo 180-8508 (JP)
(74) Representative: Samson & Partner Patentanwälte mbB
(86) International application number: PCT/JP2018/007775
(87) International publication number: WO 2018/168495

(57) **Abstract**

A secondary battery (30) includes: a first conductivity-type first oxide semiconductor (14); a first charge layer (16T) disposed on the first oxide semiconductor layer (14), the first charge layer composed by including a first metal oxide; a first separation layer (18SNS) disposed on the first charge layer (16T); and a second conductivity-type second oxide semiconductor layer (24) disposed on the first separation layer (18SNS). The first charge layer (16T) is not composed of a material containing silicon. A second separation layer (18TS) disposed on the first charge layer (16T) between the first separation layer (18SNS) and the first charge layer (16T) may be included. Provided is a secondary battery capable of reducing an internal resistance and capable of increasing an electricity storage capacity per unit volume (weight).

## Description

### TECHNICAL FIELD

The embodiments described herein relate to a secondary battery.

### BACKGROUND ART

As conventional secondary batteries, there have been proposed secondary batteries, in which a first electrode / an insulating material / an n type oxide semiconductor layer / a p type oxide semiconductor layer / a second electrode are layered, since electrolytic solutions and rare elements are not used and thinning thereof can be realized.

Moreover, as a structure similar to such secondary batteries, there have been proposed secondary batteries including: a positive electrode including a positive-electrode active material layer containing a nickel oxide or the like as a positive-electrode active material; a solid electrolyte having an aqueous porous structure; and a negative electrode including a negative-electrode active material layer containing a titanium oxide or the like as a negative-electrode active material.

Moreover, there have also been proposed secondary batteries having a structure in which an n type semiconductor layer, a charge layer, an insulation layer, and a p type semiconductor layer are layered, and electrodes are formed at upper and lower sides thereof.

Patent Literature 1: Japanese Patent No. 5508542
Patent Literature 2: Japanese Patent No. 5297809
Patent Literature 3: Japanese Patent Application Laid-Open Publication No. 2015-82445
Patent Literature 4: Japanese Patent Application Laid-Open Publication No. 2016-82125

### SUMMARY OF INVENTION

### Technical Problem

The embodiments provide a secondary battery capable of reducing an internal resistance and capable of increasing an electricity storage capacity per unit volume (weight).

### Solution to Problem

According to one aspect of the embodiments, there is provided a secondary battery comprising: a first conductivity-type first oxide semiconductor; a first charge layer disposed on the first oxide semiconductor layer, the first charge layer composed by including a first metal oxide; a first separation layer disposed on the first charge layer; and a second conductivity-type second oxide semiconductor layer disposed on the first separation layer.

### Advantageous Effects of Invention

According to the embodiments, there can be provided the secondary battery capable of reducing the internal resistance and capable of increasing the electricity storage capacity per unit volume (weight).

### BRIEF DESCRIPTION OF THE DRAWINGS

[Fig. 1] A schematic cross-sectional structure diagram showing a secondary battery according to a first embodiment.
[Fig. 2] A schematic cross-sectional structure diagram in which charge layers are multilayered, in the secondary battery according to the first embodiment.
[Fig. 3] A schematic cross-sectional structure diagram showing a secondary battery according to a second embodiment.
[Fig. 4] (a) A schematic cross-sectional structure diagram showing a secondary battery according to a third embodiment, and (b) a schematic cross-sectional structure diagram showing a secondary battery according to a modified example 1 of the third embodiment.
[Fig. 5] A schematic cross-sectional structure diagram showing a secondary battery according to a modified example 2 of the third embodiment.
[Fig. 6] A characteristics comparison of energy density ratios between the secondary batteries according to the comparative example, the second embodiment, and the third embodiment.
[Fig. 7] An example of data showing a relationship between an amount of silicone oil and a charge layer resistance, in the secondary battery according to the embodiments.
[Fig. 8] An example of data showing a relationship between an energy density ratio and a cycle count (comparison of power flux densities for cycle characteristic evaluation), in the secondary battery (C) according to the third embodiment and the secondary battery (A) according to the comparative example.

### DESCRIPTION OF EMBODIMENTS

Next, the embodiments will be described with reference to drawings. In the description of the following drawings, the identical or similar reference sign is attached to the identical or similar part. However, it should be noted that the drawings are schematic and therefore the relation between thickness and the plane size and the ratio of the thickness differs from an actual thing. Therefore, detailed thickness and size should be determined in consideration of the following explanation. Of course, the part from which the relation and ratio of a mutual size differ also in mutually drawings is included.

Moreover, the embodiments shown hereinafter exemplify the apparatus and method for materializing the technical idea; and the embodiments do not specify the material, shape, structure, placement, etc. of each component part as the following. The embodiments may be changed without departing from the spirit or scope of claims.

In explanation of following embodiments, a first conductivity type means an n type and a second conductivity type means a p type opposite to the first conductivity type, for example.

### [First Embodiment]

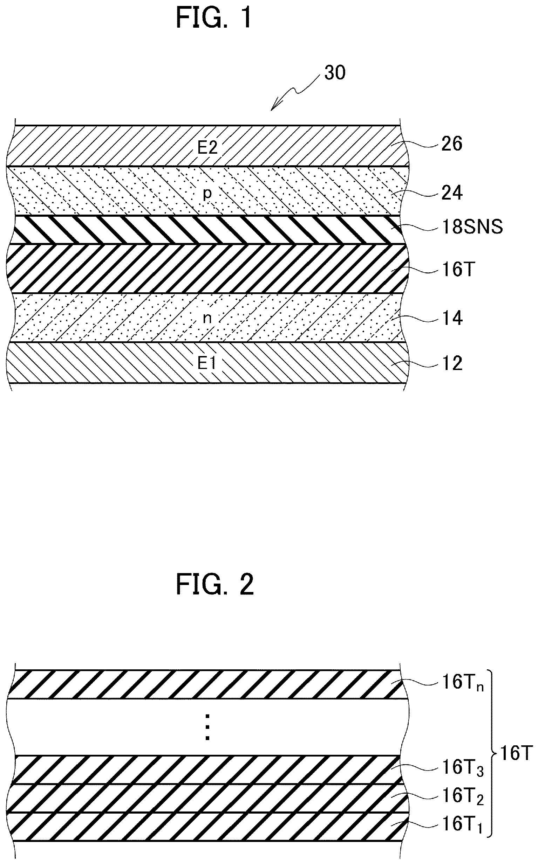

Fig. 1 shows a schematic cross-sectional structure of a secondary battery 30 according to the first embodiment, and Fig. 2 shows a schematic cross-sectional structure in which charge layers 16T are multilayered, in the secondary battery 30 according to the first embodiment.

As shown in Fig. 1, the secondary battery 30 according to the first embodiment includes: a first conductivity-type first oxide semiconductor 14; a first charge layer 16T disposed on the first oxide semiconductor layer 14, the first charge layer 16T composed by including a first metal oxide; a first separation layer 18SNS disposed on the first charge layer 16T; and a second conductivity-type second oxide semiconductor layer 24 disposed on first separation layer 18SNS; each layered between the first electrode (E1) 12 and the second electrode (E2) 26.

In the embodiments, the first conductivity-type first oxide semiconductor 14 means an oxide semiconductor layer composed by including a first conductivity-type first oxide semiconductor. The second conductivity-type second oxide semiconductor layer 24 means an oxide semiconductor layer composed by including a second conductivity-type second oxide semiconductor. The same applies hereafter.

In this case, the first charge layer 16T is not composed of a material containing silicon.

The first separation layer 18SNS may include a first insulating material.

Moreover, the first separation layer 18SNS may further include an electric conductivity adjusting material.

In this case, the electric conductivity adjusting material may include a first conductivity-type semiconductor or a metal oxide.

Alternatively, the electric conductivity adjusting material may include at least one oxide selected from the group consist of Sn, Zn, Ti, Al, Mg, or Nb oxide.

Alternatively, the first insulating material may include SiOₓ and the electric conductivity adjusting material may include SnOₓ.

Alternatively, the first insulating material may include SiOₓ formed as a film from silicone oil.

Alternatively, the first separation layer 18SNS may be mainly composed of SiOₓ.

Alternatively, the first separation layer 18SNS may be mainly composed of SiOₓ and SnOx.

Moreover, the n type oxide semiconductor layer 14 may be an oxide layer of titanium (Ti), tin (Sn), zinc (Zn), or magnesium (Mg).

Alternatively, the first metal oxide may include at least one oxide selected from the group consist of titanium (Ti), tin (Sn), zinc (Zn), and magnesium (Mg) oxides.

Moreover, the first charge layer 16T may include at least two layers having substantially the same composition.

Alternatively, the first charge layer 16T may be formed of a layered structure of thin charge layers (TiOₓ) 16T₂, 16T₃, ..., 16Tₙ, having substantially the same composition, as shown in Fig. 2. When forming the first charge layer 16T by such a layered structure in which the charge layers 16T₂, 16T₃, ..., 16Tₙ, the first charge layer 16T can be formed without causing a fatal defect. The fatal defect herein is a pinhole which passes through the first charge layer 16T, for example. When the first charge layer 16T is formed by such a layered structure, for example, even if a pinhole is generated in an any layers composing the first charge layer 16T, but if no pinhole is generated in other layers, it is possible to prevent the generation of a pinhole (fatal defect) which passes through the first charge layer 16T.

Alternatively, the first charge layer 16T may include a structure of at least two layers having compositions different from each other.

The first metal oxide may include a titanium oxide (TiOₓ) , for example. Accordingly, the charge layer 16T may be formed of TiOₓ.

The first charge layer 16T may further include hydrogen.

Moreover, the first charge layer 16T may include a porous structure.

Moreover, the second oxide semiconductor layer 24 may be composed of NiOₓ. The second oxide semiconductor layer 24 may further include hydrogen.

In the secondary battery 30 according to the first embodiment, since no silicon oxide film is contained in the first charge layer 16T, an internal resistance can be reduced and therefore battery performance can be improved.

### (First Separation Layer)

The first separation layer 18SNS is preferably a film capable of permeating hydrogen ions, an insulating film not capable of substantially conducting electrons. Moreover, permeation performance of hydrogen ions can be adjusted by further adding an electric conductivity adjusting material to the first separation layer 18SNS.

### (First Charge Layer)

The first charge layer 16T is a layer for storing hydrogen which is generated at the time of charging. In the first charge layer 16T, a reaction of MOx + H₂O + e⁻ → MH + OH⁻ progresses at the time of charging, and a reaction of MOₓH + OH⁻ → M + H₂O + e⁻ progresses at the time of discharging. If the first charge layer 16T is made porous, efficiency of storing the hydrogen can be increased. Moreover, the hydrogen storage and electrical conductivity can be optimized if the first charge layer 16T is formed as a plurality of layers. It can be optimized by forming the first metal oxide by using an oxide of Ti, Sn, Zn or Mg.

### (N type Oxide Semiconductor Layer)

As shown in Fig. 1, the secondary battery 30 according to the first embodiment may include a first electrode 12 and a second electrode 26; the first oxide semiconductor layer 14 may include an n type first oxide semiconductor layer and may be connected to the first electrode 12; the first metal oxide may include an n-type metal oxide; and the second oxide semiconductor layer 24 may include a p type second oxide semiconductor layer and may be connected to the second electrode 26.

### (Manufacturing Method in First Embodiment)

A manufacturing method of the secondary battery 30 according to the first embodiment includes: forming a first conductivity-type first oxide semiconductor 14; forming a first charge layer 16T composed by including a first metal oxide on the first oxide semiconductor layer 14; forming a first separation layer 18SNS on the first charge layer 16T; and forming the second oxide semiconductor layer 24 on first separation layer 18SNS.

In the process of forming the second oxide semiconductor layer 24, the second oxide semiconductor layer 24 may be formed by applying a sputtering deposition method, using metallic nickel Ni as a target material at the time of the sputtering, and using a reactive sputtering technology of adding oxygen to sputtering gas.

### - n type Oxide Semiconductor Layer 14 -

A TiOₓ film is formed on the first electrode 12 by the sputtering deposition method. In this case, Ti or TiOₓ can be used as a target. The layer thickness of the n type oxide semiconductor layer 14 is approximately 50 nm to 200 nm, for example. In addition, a tungsten (W) electrode or the like can be applied to the first electrode 12, for example.

### - First Charge Layer 16T -

The first charge layer 16T is formed by coating a chemical solution on the n-type first oxide semiconductor layer 14 by a spin coat method. Specifically, the chemical solution is formed by stirring titanium fatty acid with a solvent. The aforementioned chemical solution is coated on the n type oxide semiconductor layer 14 by means of a spin coater. The rotational frequency thereof is approximately 500 to approximately 3000 rpm. It is dried on a hot plate after the coating. The drying temperature on the hot plate is approximately 30°C to approximately 200°C, for example, and the drying time thereon is approximately 5 minutes to approximately 30 minutes, for example. It is fired after the drying. In the firing performed after the drying, it is fired in the atmosphere using a baking furnace. The firing temperature is approximately 300°C to approximately 600°C, and the firing time is approximately 10 minutes to approximately 60 minutes. In this case, hydrogen (H) may be added to TiOₓ composing the charge layer 16T by being fired in an atmosphere.

Accordingly, aliphatic acid salt is decomposed and then a fine particle layer of a titanium dioxide is formed. The above-mentioned manufacturing (preparation) method for the layer formation of the titanium dioxide is a coating and thermodecomposition method. After the firing, UV irradiation by means of a low pressure mercury lamp is implemented. The UV irradiation time is approximately 10 minutes to approximately 100 minutes. The thickness of the first charge layer 16T is approximately 50 nm to approximately 200 nm, for example. Moreover, the first charge layer 16T may be formed to be a layered structure to form it thicker.

### - First Separation Layer 18SNS -

The first separation layer 18SNS is formed by coating a chemical solution on the first charge layer 16T by the spin coat method. More specifically, the chemical solution is formed by stirring tin fatty acid and silicone oil with a solvent. The chemical solution is coated on the charge layer 16T by means of a spin coater. The rotational frequency thereof is approximately 500 to approximately 3000 rpm. It is dried on a hot plate after the coating. The drying temperature on the hot plate is approximately 30°C to approximately 200°C, for example, and the drying time thereon is approximately 5 minutes to approximately 30 minutes, for example. Furthermore, it is fired after the drying. In the firing performed after the drying, it is fired in the atmosphere using a baking furnace. The firing temperature is approximately 300°C to approximately 600°C, and the firing time is approximately 10 minutes to approximately 60 minutes. After the firing, UV irradiation by means of a low pressure mercury lamp is implemented. The UV irradiation time is approximately 10 minutes to approximately 100 minutes. The layer thickness of the separation layer 18SNS after the UV irradiation is approximately 50 nm to approximately 300 nm, for example.

### - p type Second Oxide Semiconductor Layer 24 -

The p type oxide semiconductor layer (NiO) 24 is formed on the first separation layer 18SNS by the sputtering deposition method. In this case, Ni or NiO can be used as a target. In the second oxide semiconductor layer 24, Ni atoms may be excited from the target due to an ion bombardment with the argon ions Ar⁺, and the excited Ni atoms may undergo a sputter deposition reaction, and thereby the second oxide semiconductor layer 24 may be deposited to be formed.

### - Second Electrode 26 -

The second electrode 26 is formed of Al with a sputtering deposition method or a vacuum evaporation method, for example. It can be formed on the p type oxide semiconductor layer (NiO) 24 using an Al target. The second electrode 26 may be formed only on a specified region using a stainless steel mask, for example.

According to the first embodiment, there can be provided the secondary battery capable of reducing the internal resistance and capable of increasing the electricity storage capacity per unit volume (weight).

### [Second Embodiment]

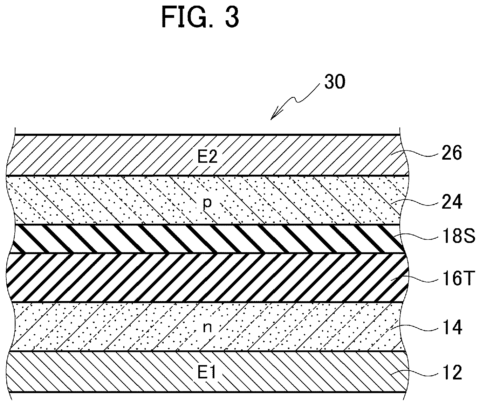

Fig. 3 shows a schematic cross-sectional structure of a secondary battery 30 according to the second embodiment, and a schematic cross-sectional structure in which charge layers 16T are multilayered is similarly shown in Fig. 2, in the secondary battery 30 according to the first embodiment.

As shown in Fig. 3, the secondary battery 30 according to the second embodiment includes: a first conductivity-type first oxide semiconductor 14; a first charge layer 16T disposed on the first oxide semiconductor layer 14, the first charge layer 16T composed by including a first metal oxide; a first separation layer 18S disposed on the first charge layer 16T; and a second conductivity-type second oxide semiconductor layer 24 disposed on the first separation layer 18S; each layered between the first electrode (E1) 12 and the second electrode (E2) 26.

In this case, the first charge layer 16T is not composed of a material containing silicon.

The first separation layer 18S may include a first insulating material.

Alternatively, the first separation layer 18S may be mainly composed of SiOₓ.

Alternatively, the first insulating material may include SiOₓ formed as a film from silicone oil.

Alternatively, the first insulating material may include SiOₓ.

Moreover, the n type first oxide semiconductor layer 14 may be an oxide layer of titanium (Ti), tin (Sn), zinc (Zn), or magnesium (Mg).

Alternatively, the first metal oxide may include at least one oxide selected from the group consist of titanium (Ti), tin (Sn), zinc (Zn), and magnesium (Mg) oxides.

Moreover, the first charge layer 16T may include at least two layers having substantially the same composition.

Alternatively, the first charge layer 16T may be formed of a layered structure of thin charge layers (TiOₓ) 16T₂, 16T₃, ..., 16Tₙ, having substantially the same composition, as shown in Fig. 2. When forming the first charge layer 16T by such a layered structure in which the charge layers 16T₂, 16T₃, ..., 16Tₙ, the first charge layer 16T can be formed without causing a fatal defect.

Alternatively, the first charge layer 16T may include a structure of at least two layers having compositions different from each other.

The first metal oxide may include a titanium oxide (TiOₓ) , for example. Accordingly, the first charge layer 16T may be formed of TiOₓ.

The first charge layer 16T may further include hydrogen.

Moreover, the first charge layer 16T may include a porous structure.

Moreover, the second oxide semiconductor layer 24 may be composed of NiOₓ. The second oxide semiconductor layer 24 may further include hydrogen.

In the secondary battery 30 according to the second embodiment, since no silicon oxide film is contained in the first charge layer 16T, an internal resistance can be reduced and therefore battery performance can be improved.

### (First Separation Layer)

The first separation layer 18S is preferably a film capable of permeating hydrogen ions, an insulating film not capable of substantially conducting electrons.

### (First Charge Layer)

The first charge layer 16T is a layer for storing hydrogen which is generated at the time of charging. In the first charge layer 16T, a reaction of MOx + H₂O + e⁻ → MH + OH⁻ progresses at the time of charging, and a reaction of MOₓH + OH⁻ → M + H₂O + e⁻ progresses at the time of discharging. If the first charge layer 16T is made porous, efficiency of storing the hydrogen can be increased. Moreover, the hydrogen storage and electrical conductivity can be optimized if the first charge layer 16T is formed as a plurality of layers. The hydrogen storage and electrical conductivity can be optimized by forming the first metal oxide by using an oxide of Ti, Sn, Zn or Mg.

### (N type Oxide Semiconductor Layer)

As shown in Fig. 3, the secondary battery 30 according to the second embodiment may include a first electrode 12 and a second electrode 26; the first oxide semiconductor layer 14 may include an n type first oxide semiconductor layer and may be connected to the first electrode 12; the first metal oxide may include an n-type metal oxide; and the second oxide semiconductor layer 24 may include a p type second oxide semiconductor layer and may be connected to the second electrode 26.

### (Manufacturing Method in Second Embodiment)

A manufacturing method of the secondary battery 30 according to the second embodiment includes: forming a first conductivity-type first oxide semiconductor 14; forming a first charge layer 16T composed by including a first metal oxide on the first oxide semiconductor layer 14; forming a first separation layer 18S on the first charge layer 16T; and forming the second oxide semiconductor layer 24 on first separation layer 18S.

In the process of forming the second oxide semiconductor layer 24, the second oxide semiconductor layer 24 may be formed by applying a sputtering deposition method, using metallic nickel Ni as a target material at the time of the sputtering, and using a reactive sputtering technology of adding oxygen to sputtering gas.

### - n type Oxide Semiconductor Layer 14 -

A TiOₓ film is formed on the first electrode 12 by the sputtering deposition method. In this case, Ti or TiOₓ can be used as a target. The layer thickness of the n type oxide semiconductor layer 14 is approximately 50 nm to 200 nm, for example. In addition, a tungsten (W) electrode or the like can be applied to the first electrode 12, for example.

### - First Charge Layer 16T -

The first charge layer 16T is formed by coating a chemical solution on the n-type first oxide semiconductor layer 14 by a spin coat method. Specifically, the chemical solution is formed by stirring titanium fatty acid with a solvent. The aforementioned chemical solution is coated on the n type oxide semiconductor layer 14 by means of a spin coater. The rotational frequency thereof is approximately 500 to approximately 3000 rpm. It is dried on a hot plate after the coating. The drying temperature on the hot plate is approximately 30°C to approximately 200°C, for example, and the drying time thereon is approximately 5 minutes to approximately 30 minutes, for example. It is fired after the drying. In the firing performed after the drying, it is fired in the atmosphere using a baking furnace. The firing temperature is approximately 300°C to approximately 600°C, and the firing time is approximately 10 minutes to approximately 60 minutes. In this case, hydrogen (H) may be added to TiOₓ composing the first charge layer 16T by being fired in an atmosphere.

Accordingly, aliphatic acid salt is decomposed and then a fine particle layer of a titanium dioxide is formed. The above-mentioned manufacturing (preparation) method for the layer formation of the titanium dioxide is a coating and thermodecomposition method. After the firing, UV irradiation by means of a low pressure mercury lamp is implemented. The UV irradiation time is approximately 10 minutes to approximately 100 minutes. The thickness of the first charge layer 16T is approximately 50 nm to approximately 200 nm, for example. Moreover, the first charge layer 16T may be formed to be a layered structure to form it thicker.

### - First Separation Layer 18S -

The first separation layer 18S is formed by coating a chemical solution on the first charge layer 16T by the spin coat method. More specifically, the chemical solution is formed by stirring silicone oil with a solvent. The aforementioned chemical solution is coated on the first charge layer 16T by means of the spin coater. The rotational frequency thereof is approximately 500 to approximately 3000 rpm. It is dried on a hot plate after the coating. The drying temperature on the hot plate is approximately 50°C to approximately 200°C, for example, and the drying time thereon is approximately 5 minutes to approximately 30 minutes, for example. Furthermore, it is fired after the drying. In the firing performed after the drying, it is fired in the atmosphere using a baking furnace. The firing temperature is approximately 300°C to approximately 600°C, and the firing time is approximately 10 minutes to approximately 60 minutes. After the firing, UV irradiation by means of a low pressure mercury lamp is implemented. The UV irradiation time is approximately 10 minutes to approximately 60 minutes. The layer thickness of the separation layer 18S after the UV irradiation is approximately 5 nm to approximately 30 nm, for example.

### - p type Second Oxide Semiconductor Layer 24 -

The p type oxide semiconductor layer (NiO) 24 is formed on the first separation layer 18S by the sputtering deposition method. In this case, Ni or NiO can be used as a target. In the second oxide semiconductor layer 24, Ni atoms may be excited from the target due to an ion bombardment with the argon ions Ar⁺, and the excited Ni atoms may undergo a sputter deposition reaction, and thereby the second oxide semiconductor layer 24 may be deposited to be formed.

### - Second Electrode 26 -

The second electrode 26 is formed of Al with a sputtering deposition method or a vacuum evaporation method, for example. It can be formed on the p type oxide semiconductor layer (NiO) 24 using an Al target. The second electrode 26 may be formed only on a specified region using a stainless steel mask, for example.

According to the second embodiment, battery performance equivalent to that of the first embodiment can be shown, and an energy density ratio equivalent thereto can be obtained.

According to the second embodiment, there can be provided the secondary battery capable of reducing the internal resistance and capable of increasing the electricity storage capacity per unit volume (weight).

### [Third Embodiment]

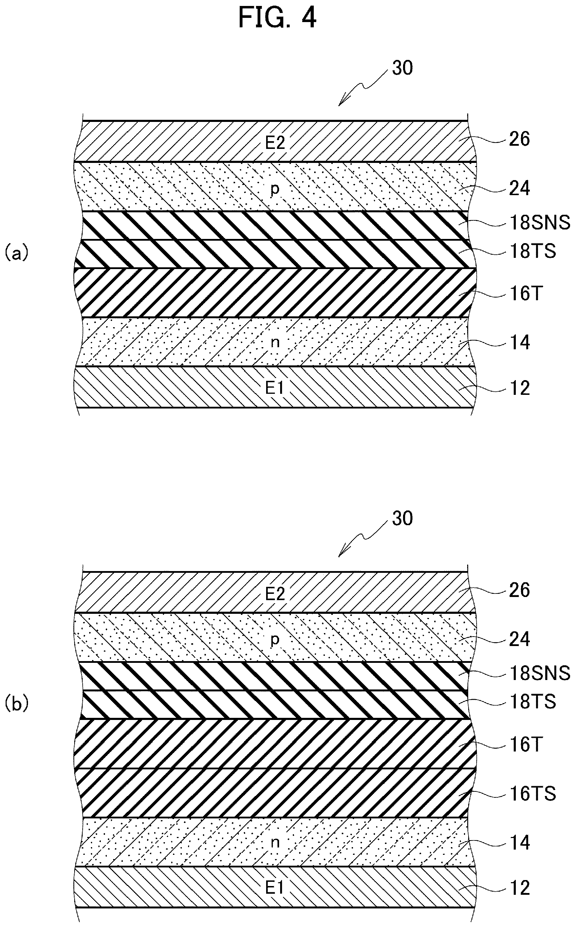

Fig. 4(a) shows a schematic cross-sectional structure of a secondary battery 30 according to a third embodiment, and Fig. 4(b) shows a schematic cross-sectional structure of a secondary battery according to a modified example 1 of the third embodiment. A schematic cross-sectional structure in which charge layers 16T are multilayered is similarly shown in Fig. 2, in the secondary batteries 30 according to the third embodiment and the modified example 1 thereof.

As shown in Fig. 4(a), the secondary battery 30 according to the third embodiment includes: a first conductivity-type first oxide semiconductor 14; a first charge layer 16T disposed on the first oxide semiconductor layer 14, the first charge layer 16T composed by including a first metal oxide; a second separation layer 18TS disposed on the first charge layer 16T; a first separation layer 18SNS disposed on the second separation layer 18TS; and a second conductivity-type second oxide semiconductor layer 24 disposed on first separation layer 18SNS: each layered between the first electrode (E1) 12 and the second electrode (E2) 26.

More specifically, the secondary battery 30 according to the third embodiment may include the second separation layer 18TS disposed on the first charge layer 16T between the first separation layer 18SNS and the first charge layer 16T, as shown in Fig. 4(a).

Moreover, the secondary battery 30 according to the modified example 1 of the third embodiment may include the second charge layer 16TS disposed on the first oxide semiconductor layer 14 between the first oxide semiconductor layer 14 and the first charge layer 16T, and the second charge layer 16TS is composed by including a second insulating material and a second metal oxide, as shown in Fig. 4(b).

In this case, the first charge layer 16T is not composed of a material containing silicon.

The first separation layer 18SNS and the second separation layer 18TS may include the first insulating material.

Moreover, the first separation layer 18SNS may further include an electric conductivity adjusting material.

In this case, the electric conductivity adjusting material may include a first conductivity-type semiconductor or a metallic oxide.

Alternatively, the electric conductivity adjusting material may include at least one oxide selected from the group consist of Sn, Zn, Ti, Al, Mg, or Nb oxide.

Alternatively, the first insulating material may include SiOₓ and the electric conductivity adjusting material may include SnOₓ.

The first insulating material of the first separation layer 18SNS and the second separation layer 18TS may be mainly composed of SiOₓ which is formed from silicone oil.

The separation layers may be composed of a layer mainly using SiOₓ and SnOx, and may be mainly composed of SiOₓ and TiOₓ. More specifically, the first separation layer 18SNS is mainly composed of SiOₓ and SnOx, for example, and the second separation layer 18TS may be mainly composed of SiOₓ and TiOₓ, for example.

Moreover, the second charge layer may be mainly composed of SiOₓ and TiOₓ.

Moreover, the n type oxide semiconductor layer 14 may be an oxide layer of titanium (Ti), tin (Sn), zinc (Zn), or magnesium (Mg).

Alternatively, the first metal oxide may include at least one oxide selected from the group consist of titanium (Ti), tin (Sn), zinc (Zn), and magnesium (Mg) oxides.

Moreover, the first charge layer 16T may include at least two layers having substantially the same composition.

Alternatively, the first charge layer 16T may be formed of a layered structure of thin charge layers (TiOₓ) 16T₂, 16T₃, ..., 16Tₙ, having substantially the same composition, as shown in Fig. 2. When forming the first charge layer 16T by such a layered structure in which the charge layers 16T₂, 16T₃, ..., 16Tₙ, the first charge layer 16T can be formed without causing a fatal defect.

Alternatively, the first charge layer 16T may include a structure of at least two layers having compositions different from each other.

The first metal oxide may include a titanium oxide (TiOₓ) , for example. Accordingly, the first charge layer 16T may be formed of TiOₓ.

The first charge layer 16T may further include hydrogen.

Moreover, the first charge layer 16T may include a porous structure.

Moreover, the second oxide semiconductor layer 24 may be composed of NiOₓ. The second oxide semiconductor layer 24 may further include hydrogen.

In the secondary battery 30 according to the third embodiment, since no silicon oxide film is contained in the first charge layer 16T, an internal resistance can be reduced and therefore battery performance can be improved.

### (Separation Layers)

The first separation layer 18SNS and the second separation layer 18TS are preferably films capable of permeating hydrogen ions, insulating films not capable of substantially conducting electrons. Moreover, permeation performance of hydrogen ions may be adjusted by further adding an electric conductivity adjusting material to the first separation layer 18SNS.

By adding the second separation layer 18TS below the first separation layer 18SNS, the breakdown voltage can be improved, and cycle degradation can be improved, and a self-discharge can be suppressed more satisfactory.

### (Charge Layers)

The first charge layer 16T and the second charge layer 16TS are layers for storing hydrogen which is generated at the time of charging. In the first charge layer 16T and the second charge layer 16TS, a reaction of MOₓ + H₂O + e⁻ → MH + OH⁻ progresses at the time of charging, and a reaction of MOₓH + OH⁻ → M + H₂O + e⁻ progresses at the time of discharging. If the charge layers are made porous, efficiency of storing the hydrogen can be increased. Moreover, the hydrogen storage and electrical conductivity can be optimized if the charge layers are formed as a plurality of layers. It can be optimized by forming the first metal oxide by using an oxide of Ti, Sn, Zn or Mg. Moreover, the second charge layer is mainly composed of SiOₓ and TiOₓ.

### (N type Oxide Semiconductor Layer)

As shown in Figs. 4A and 4B, the secondary batteries 30 according to the third embodiment and the modified example 1 thereof may include a first electrode 12 and a second electrode 26; the first oxide semiconductor layer 14 may include an n type first oxide semiconductor layer and may be connected to the first electrode 12; the first metal oxide may include an n-type metal oxide; and the second oxide semiconductor layer 24 may include a p type second oxide semiconductor layer and may be connected to the second electrode 26.

### (Manufacturing Method in third Embodiment)

A manufacturing method of the secondary battery 30 according to the third embodiment includes: forming a first conductivity-type first oxide semiconductor 14; forming a first charge layer 16T composed by including a first metal oxide on the first oxide semiconductor layer 14; forming a second separation layer 18TS on the first charge layer 16T; forming a first separation layer 18SNS on the second separation layer 18TS; and forming the second oxide semiconductor layer 24 on first separation layer 18SNS.

Moreover, the manufacturing method of the secondary battery 30 according to the modified example 1 of the third embodiment may include forming a second charge layer 16TS disposed on the first oxide semiconductor layer 14 between the first oxide semiconductor layer 14 and the first charge layer 16T, in which the second charge layer 16TS is composed by including a second insulating material and a second metal oxide, as shown in Fig. 4(b).

In the process of forming the second oxide semiconductor layer 24, the second oxide semiconductor layer 24 may be formed by applying a sputtering deposition method, using metallic nickel Ni as a target material at the time of the sputtering, and using a reactive sputtering technology of adding oxygen to sputtering gas.

### - n type Oxide Semiconductor Layer 14 -

A TiOₓ film is formed on the first electrode 12 by the sputtering deposition method. In this case, Ti or TiOₓ can be used as a target. The layer thickness of the n type oxide semiconductor layer 14 is approximately 50 nm to 200 nm, for example. In addition, a tungsten (W) electrode or the like can be applied to the first electrode 12, for example.

### - First Charge Layer 16T -

In the manufacturing method of the secondary battery 30 according to the third embodiment, as shown in Fig. 4(a), the first charge layer 16T is formed by coating a chemical solution on the n type oxide semiconductor layer 14 with a spin coat method. Moreover, in the manufacturing method of the secondary battery 30 according to the modified example 1 of the third embodiment, as shown in Fig. 4(b), the first charge layer 16T is formed by coating the chemical solution on second charge layer 16TS with the spin coat method. Specifically, the chemical solution is formed by stirring titanium fatty acid with a solvent. The aforementioned chemical solution is coated on the n type oxide semiconductor layer 14 by means of a spin coater. The rotational frequency thereof is approximately 500 to approximately 3000 rpm. It is dried on a hot plate after the coating. The drying temperature on the hot plate is approximately 30°C to approximately 200°C, for example, and the drying time thereon is approximately 5 minutes to approximately 30 minutes, for example. It is fired after the drying. In the firing performed after the drying, it is fired in the atmosphere using a baking furnace. The firing temperature is approximately 300°C to approximately 600°C, and the firing time is approximately 10 minutes to approximately 60 minutes. In this case, hydrogen (H) may be added to TiOₓ composing the charge layer 16T by being fired in an atmosphere.

Accordingly, aliphatic acid salt is decomposed and then a fine particle layer of a titanium dioxide is formed. The above-mentioned manufacturing (preparation) method for the layer formation of the titanium dioxide is a coating and thermodecomposition method. After the firing, UV irradiation by means of a low pressure mercury lamp is implemented. The UV irradiation time is approximately 10 minutes to approximately 100 minutes. The thickness of the first charge layer 16T is approximately 50 nm to approximately 200 nm, for example. Moreover, the first charge layer 16T may be formed to be a layered structure to form it thicker.

### - Second Charge Layer 16TS -

In the manufacturing method of the secondary battery 30 according to the modified example 1 of the third embodiment, as shown in Fig. 4(b), the second charge layer 16TS is formed by coating a chemical solution on the n type first oxide semiconductor layer 14 with a spin coat method. More specifically, the chemical solution is formed by stirring titanium fatty acid and silicone oil with a solvent. The aforementioned chemical solution is coated on the n type oxide semiconductor layer 14 by means of a spin coater. The rotational frequency thereof is approximately 500 to approximately 3000 rpm. It is dried on a hot plate after the coating. The drying temperature on the hot plate is approximately 30°C to approximately 200°C, for example, and the drying time thereon is approximately 5 minutes to approximately 30 minutes, for example. It is fired after the drying. In the firing performed after the drying, it is fired in the atmosphere using a baking furnace. The firing temperature is approximately 300°C to approximately 600°C, and the firing time is approximately 10 minutes to approximately 60 minutes.

Consequently, aliphatic acid salt is decomposed and then a fine particle layer of a titanium dioxide covered with a silicone insulating film is formed. The above-mentioned manufacturing (preparation) method of forming the titanium dioxide layer covered with the silicone insulating film is a coating and thermodecomposition method. After the firing, UV irradiation by means of a low pressure mercury lamp is implemented. The UV irradiation time is approximately 10 minutes to approximately 100 minutes. The layer thickness of the second charge layer 16TS after the UV irradiation is approximately 50 nm to approximately 300 nm, for example.

### - Second Separation Layer 18TS -

The second separation layer 18TS is formed by coating a chemical solution on the first charge layer 16T by the spin coat method. More specifically, the chemical solution is formed by stirring titanium fatty acid and silicone oil with a solvent. The chemical solution is coated on the charge layer 16T by means of a spin coater. The rotational frequency thereof is approximately 500 to approximately 3000 rpm. It is dried on a hot plate after the coating. The drying temperature on the hot plate is approximately 30°C to approximately 200°C, for example, and the drying time thereon is approximately 5 minutes to approximately 30 minutes, for example. It is fired after the drying. In the firing performed after the drying, it is fired in the atmosphere using a baking furnace. The firing temperature is approximately 300°C to approximately 600°C, and the firing time is approximately 10 minutes to approximately 60 minutes.

Consequently, aliphatic acid salt is decomposed and then a fine particle layer of a titanium dioxide covered with a silicone insulating film is formed. The above-mentioned manufacturing (preparation) method of forming the titanium dioxide layer covered with the silicone insulating film is a coating and thermodecomposition method. After the firing, UV irradiation by means of a low pressure mercury lamp is implemented. The UV irradiation time is approximately 10 minutes to approximately 100 minutes. The layer thickness of the second separation layer 18TS after the UV irradiation is approximately 5 nm to approximately 30 nm, for example.

### - First Separation Layer 18SNS -

The first separation layer 18SNS is formed by coating a chemical solution on the second separation layer 18TS by the spin coat method. More specifically, the chemical solution is formed by stirring tin fatty acid and silicone oil with a solvent. The chemical solution is coated on the charge layer 16T by means of a spin coater. The rotational frequency thereof is approximately 500 to approximately 3000 rpm. It is dried on a hot plate after the coating. The drying temperature on the hot plate is approximately 30°C to approximately 200°C, for example, and the drying time thereon is approximately 5 minutes to approximately 30 minutes, for example. Furthermore, it is fired after the drying. In the firing performed after the drying, it is fired in the atmosphere using a baking furnace. The firing temperature is approximately 300°C to approximately 600°C, and the firing time is approximately 10 minutes to approximately 60 minutes. After the firing, UV irradiation by means of a low pressure mercury lamp is implemented. The UV irradiation time is approximately 10 minutes to approximately 100 minutes. The layer thickness of the first separation layer 18SNS after the UV irradiation is approximately 5 nm to approximately 30 nm, for example.

### - p type Second Oxide Semiconductor Layer 24 -

The p type oxide semiconductor layer (NiOₓ) 24 is formed on the first separation layer 18SNS by the sputtering deposition method. In this case, Ni or NiO can be used as a target. In the p type second oxide semiconductor layer 24, Ni atoms may be excited from the target due to an ion bombardment with the argon ions Ar⁺, and the excited Ni atoms may undergo a sputter deposition reaction, and thereby the second oxide semiconductor layer 24 may be deposited to be formed.

### - Second Electrode 26 -

The second electrode 26 is formed of Al with a sputtering deposition method or a vacuum evaporation method, for example. It can be formed on the p type oxide semiconductor layer (nickel oxide (NiO)) 24 using an Al target. The second electrode 26 may be formed only on a specified region using a stainless steel mask, for example.

According to the third embodiment and the modified example 1 thereof, by adding the second separation layer below the first separation layer, the breakdown voltage can be improved, and cycle degradation can be improved, and a self-discharge can be suppressed more satisfactory, as compared with the first embodiment.

According to the third embodiment and its modified example 1, there can be provided the secondary battery capable of reducing the internal resistance and capable of increasing the electricity storage capacity per unit volume (weight).

### (Modified Example 2)

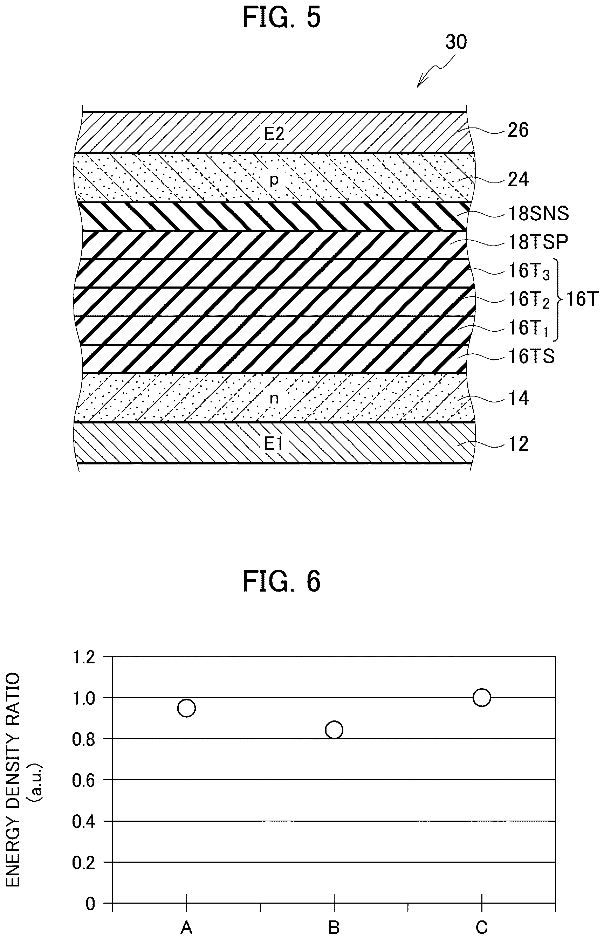

Fig. 5 shows a schematic cross-sectional structure of a secondary battery 30 according to a modified example 2 of the third embodiment.

As shown in Fig. 5, the secondary battery 30 according to the modified example 2 of the third embodiment includes: a first oxide semiconductor layer 14; a second charge layer 16TS disposed on the first oxide semiconductor layer 14, the second charge layer 16TS composed by including a second insulating material and a second metal oxide; a first charge layer 16T disposed on the second charge layer 16TS, the first charge layer 16T composed by including a first metal oxide; a second separation layer 18TSP disposed on the first charge layer 16T, a first separation layer 18SNS disposed on the second separation layer 18TSP; and a second conductivity-type second oxide semiconductor layer 24 disposed on first separation layer 18SNS.

The first charge layer 16T is formed o a 3-layered structure composed of charge layers 16T₁, 16T₂, and 16T₃.

Moreover, the charge layers 16T₁, 16T₂, and 16T₃ may have substantially the same composition.

Alternatively, the first charge layer 16T may be formed of a layered structure of thin charge layers (TiOₓ) 16T₁, 16T₂, and 16T₃, having substantially the same composition. When forming the first charge layer 16T by such a layered structure in which the charge layers 16T₂ and 16T₃, the first charge layer 16T can be formed without causing a fatal defect.

Alternatively, the first charge layers 16T₁, 16T₂, and 16T₃ may have compositions different from one another.

The second charge layer 16TS and the second separation layer 18TSP which are composed by including the second insulating material and the second metal oxide can be formed respectively in the same manner as the second charge layer 16TS and the second separation layer 18TS in the third embodiment.

The second separation layer 18TSP and the first separation layer 18SNS are preferably films capable of permeating hydrogen ions, insulating films not capable of substantially conducting electrons. Other configurations are the same as those of the third embodiment.

According to the modified example 2 of the third embodiment, by multilayering the first charge layer, the yield and breakdown voltage can be improved, and cycle degradation can be improved, and a self-discharge can be suppressed more satisfactory.

### (Energy Density)

Fig. 6 shows a characteristics comparative example of the energy density ratios of the secondary batteries according to the comparative example, the second embodiment, and the third embodiment.

In Fig. 6, the plots corresponding to A, B, and C of the horizontal axis show respectively energy density ratios of the comparative example, the second embodiment, and the third embodiment.

The secondary battery according to the comparative example herein corresponds to an example of including a structure in which the first charge layer 16T is formed using titanium fatty acid and silicone oil in the secondary battery according to the first embodiment.

In the secondary battery (A) according to the comparative example, the first separation layer/the first charge layer include a structure of SnOₓ+SiOₓ/TiOx+SiOx. In the secondary battery according to the second embodiment (B), the first separation layer/the first charge layer include a structure of SiOₓ/TiOₓ. In the secondary battery according to the third embodiment (C), the separation layer includes a double layered structure of SnOₓ+SiOₓ/TiOₓ+SiOₓ, and the charge layer includes a structure of TiOₓ.

In the secondary battery according to the second embodiment (B) in which no silicone oil is used for the formation of the first charge layer and SiOₓ is used for the first separation layer instead of SnOₓ+SiOₓ, the energy density ratio is slightly lower than that of the comparative example (A), as shown in Fig. 6. On the other hand, in the secondary battery according to the third embodiment (B) in which no silicone oil is used for the formation of the first charge layer and the separation layer is formed to be the double layered structure of SnOₓ+SiOₓ/TiOₓ+SiOₓ, the energy density ratio slightly higher than that of the comparative example (A) is obtained, as shown in Fig. 6.

### (Internal Resistance of Charge Layer)

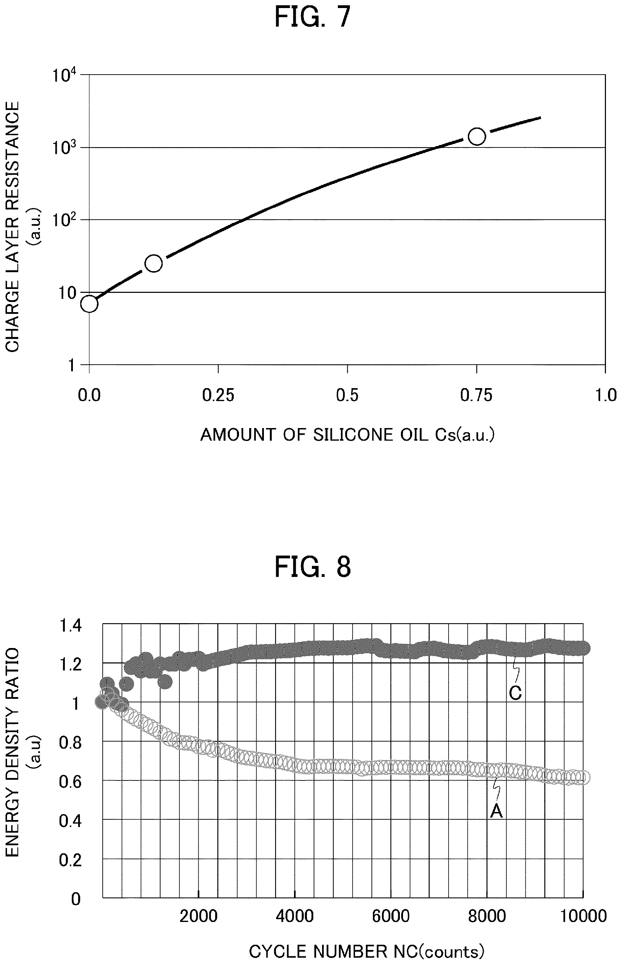

Fig. 7 shows an example of data showing a relationship between an amount of silicone oil Cₛ used for the formation of the charge layer and an internal resistance of the charge layer. There is a tendency to increase the internal resistance (charge layer resistance) of the charge layer, as the amount of the silicone oil Cₛ is increased. The data of which the amount of the silicone oil Cₛ is zero corresponds to the charge layer resistance of the secondary battery according to the third embodiment.

### (Cycle Characteristics)

Fig. 8 shows an example of data showing a relationship between an energy density ratio and a cycle count NC (comparison of power flux densities for cycle characteristic evaluation), in the secondary battery (C) according to the third embodiment and the secondary battery (A) according to the comparative example.

In the secondary battery (A) according to the comparative example, reduction of the energy density ratio is observed as the cycle count is increased. On the other hand, in the secondary battery according to the third embodiment (C), even if the cycle count NC is increased, the energy density ratio shows flat characteristics.

In the secondary battery (A) according to the comparative example, since the silicone oil is used for the formation of the charge layer, the charge layer includes the SiOₓ layer. Accordingly, the internal electrical resistance of the charge layer is increased, and thereby battery performance, such as cycle characteristics, is reduced.

On the other hand, in the secondary battery according to the third embodiment (C), since no silicone oil is used for the formation of the charge layer, the charge layer includes no SiOₓ layer and is still the TiOₓ layer. Accordingly, an increase in the internal resistance of the charge layer is suppressed, satisfactory cycle characteristics are exhibited, and therefore the battery performance can be improved.

### [Other embodiments]

As explained above, the embodiments have been described, as a disclosure including associated description and drawings to be construed as illustrative, not restrictive. This disclosure makes clear a variety of alternative embodiments, working examples, and operational techniques for those skilled in the art.

For example, a structure of the secondary battery 30 according to the embodiments is made in a sheet shape by using stainless steel foil as a substrate. Subsequently, this sheet may be laminated to produce the secondary battery 30 with a required capacity.

For example, a secondary battery with a required capacity can be manufactured by opposing two sheets of the second electrodes, inserting an electrode (thin metal foil) therebetween, and laminating the two sheets in multiple layers. It may be sealed with a laminate or the like after the laminating.

Such being the case, the embodiments cover a variety of embodiments, whether described or not.

### INDUSTRIAL APPLICABILITY

The secondary battery according to the embodiments can be utilized for various consumer equipment and industrial equipment, and can be applied to wide applicable fields, such as secondary batteries for system applications capable of transmitting various kinds of sensor information with low power consumption, e.g. communication terminals and secondary batteries for wireless sensor networks.

### Reference Signs List

- 12:: First electrode (E1)
- 14:: First oxide semiconductor layer
- 16T, 16TS, 16T₁, 16T₂, 16T₃, ..., 16Tₙ:: Charge layer
- 18SNS, 18S, 18TS, 18TSP:: Separation layer
- 24:: second oxide semiconductor layer
- 26:: Second electrode (E2)
- 30:: Secondary battery

## Claims

1. A secondary battery comprising:
a first conductivity-type first oxide semiconductor;
a first charge layer disposed on the first oxide semiconductor layer, the first charge layer composed by comprising a first metal oxide;
a first separation layer disposed on the first charge layer; and
a second conductivity-type second oxide semiconductor layer disposed on the first separation layer.

2. The secondary battery according to claim 1, wherein
the first charge layer is not composed of a material containing silicon.

3. The secondary battery according to claim 1, further comprising
a second separation layer disposed on the first charge layer between the first separation layer and the first charge layer.

4. The secondary battery according to any one of claims 1-3, further comprising
a second charge layer disposed on the first oxide semiconductor layer between the first oxide semiconductor layer and the first charge layer, the second charge layer composed by comprising a second insulating material and a second metal oxide.

5. The secondary battery according to any one of claims 1-4, wherein
the first charge layer comprises at least two layers having substantially the same composition.

6. The secondary battery according to any one of claims 1-4 wherein
the first charge layer comprises at least two layers having compositions different from each other.

7. The secondary battery according to any one of claims 1-6, wherein
the first separation layer comprises a first insulating material.

8. The secondary battery according to claim 7, wherein
the first separation layer further comprises an electric conductivity adjusting material.

9. The secondary battery according to claim 8, wherein
the electric conductivity adjusting material comprises a first conductivity-type semiconductor or a metallic oxide.

10. The secondary battery according to claim 8 or 9, wherein
the electric conductivity adjusting material comprises at least one oxide selected from the group consist of Sn, Zn, Ti, Al, Mg, or Nb oxide.

11. The secondary battery according to claim 8, wherein
the first insulating material comprises SiOₓ, and the electric conductivity adjusting material comprises SnOₓ.

12. The secondary battery according to any one of claims 1-11, wherein
the first separation layer is mainly composed of SiOₓ.

13. The secondary battery according to any one of claims 1-11, wherein
the first separation layer is mainly composed of SiOₓ and SnOx.

14. The secondary battery according to claim 3, wherein
the first separation layer is mainly composed of SiOₓ and SnOₓ, and the second separation layer is mainly composed of SiOₓ and TiOₓ.

15. The secondary battery according to any one of claims 1-14, wherein
the first oxide semiconductor comprises at least one oxide selected from the group consist of an oxide of Ti, an oxide of Sn, an oxide of Zn, and an oxide of Mg.

16. The secondary battery according to any one of claims 1-14, wherein
the first metal oxide comprises TiOₓ.

17. The secondary battery according to any one of claims 1-16, wherein
the second oxide semiconductor layer is composed by comprising NiOₓ.

18. The secondary battery according to claim 17, wherein
the second oxide semiconductor layer further comprises hydrogen.

19. The secondary battery according to claim 4, wherein
the second charge layer is mainly composed of SiOₓ and TiOₓ.
